# EUROPEAN PATENT SPECIFICATION

(11) **EP 1 031 995 B1**
(45) Date of publication and mention of the grant of the patent: **22.05.2002**
(21) Application number: 99103479.4
(22) Date of filing: 23.02.1999
(51) Int. Cl.: G11C 29/00, G01R 31/3181

(54) **Built-in self-test circuit for memory**
Speicherschaltung mit eingebautem Selbsttest
Circuit de mémoire à auto-test incorporé

(43) Date of publication of application: 30.08.2000
(73) Proprietor: Taiwan Semiconductor Manufacturing Co., Ltd., Hsin-Chu 300 (TW)
(72) Inventor: Huang, Shi-Yu, Hsinchu, TW (TW); Kwai, Ding-Ming, Hsinchu, TW (TW)
(74) Representative: Viering, Jentschura & Partner

(56) References cited:
- EP-A- 0 859 367
- US-A- 4 049 956
- US-A- 5 673 271

## Description

### BACKGROUND OF THE INVENTION

### Field of the Invention

The invention relates to a test and a test hardware of a memory. More particularly, the invention relates to a built-in self-test circuit for memories embedded on the same chip.

### Description of the Related Art

Memories are susceptible to fabrication process related failures caused by dust particles on the chips or masks, scratches and gate oxide pinholes, which may results open or short circuits. Many methods or hardwares have been developed to test whether a memory can function normally. However, as the integrated circuit art becomes more and more advanced, functions of memories become much more and more complex. Consequently, it often takes a great time and requires a complex circuit to perform a functional test of the memories.

Techniques of built-in self-test (BIST) for memories have been developed to resolve the above problems. In the built-in self test technique for memory, a test algorithm is translated into a sequence of commands, data, and addresses applied to the memory under test. Traditionally, a hard-wired finite state machine (FSM) is used to implement the translation process. To provide the capability of at-speed testing, the BIST circuit operates as fast as the memory under test. A disadvantage of the approach is that the finite state machine is tailored to a specific set of test patterns whose complexity depends on the test algorithm. As the complexity of the test algorithm increases, this approach may be inadequate because the finite state machine may become too large and too slow to produce a test pattern in each clock cycle to intensively exercise the memory under test.

Some BIST circuits, known to be the programmable or configurable BIST circuits, can be referred to U.S Patent No. 5,173,906, "Built-in Self-Test for Integrated Circuit" disclosed by Dreibelbis et al, in 1992. Another disclosure of a circuit that uses a micro-coded sequence defined in the contents of a read-only memory to produce the test patterns is issued with a US Patent No 5,224,101 to Popyack et al in 1993. In US Patent No. 5,301,156, "Configurable Self-Test for Embedded RAMs". Talley et al discloses a circuit that has a serial path which passes through the address, command, and data portions of the circuit to shift in a test or control pattern and to shift out the results, each scan requiring several clock cycles.

### SUMMARY OF THE INVENTION

Accordingly, the invention provides a circuit for testing a memory, especially for testing of a memory device. The circuit comprises a pattern generator, a built-in self-test output buffer, a delay buffer, and a comparator. The pattern generator further comprises three modules, a finite state machine to generate data and commands of test patterns, an address generator to perform address computation, and a prediction logic to predict an address of a next clock cycle based on the address information of a previous cycle.

The invention adapts a cyclic path breaking technique. By inserting flip-flops into an original critical path of the pattern generator, the original critical path is broken into segments. Thus, the clock-cycle time of the pattern generator is thus dominated by a longest clock-cycle time among these segments. However, as the flip-flops are inserted into the original critical path, clock cycles are delayed. To offset the delayed clock cycles by the insertion of the flip-flops, a prediction logic is inserted between flip-flops. As a consequence, the latency caused by the insertion of flip-flops is resolved, while the clock-cycle time of the pattern generator is effectively reduced.

It is to be understood that both the foregoing general description and the following detailed description are exemplary and explanatory only and are not restrictive of the invention, as claimed.

### BRIEF DESCRIPTION OF THE DRAWINGS

Figure 1 shows a block diagram of a built-in self-test circuit for testing a memory device;
Figure 2(a) to Fig. 2(c) shows an evolvement of a pattern generator in a built-in self-test circuit according to the invention, wherein

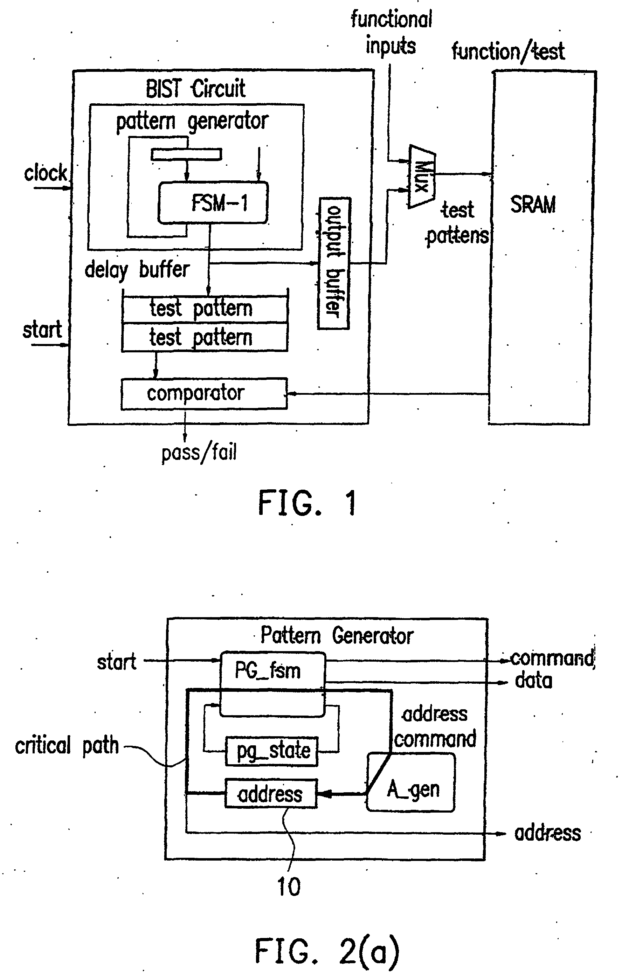

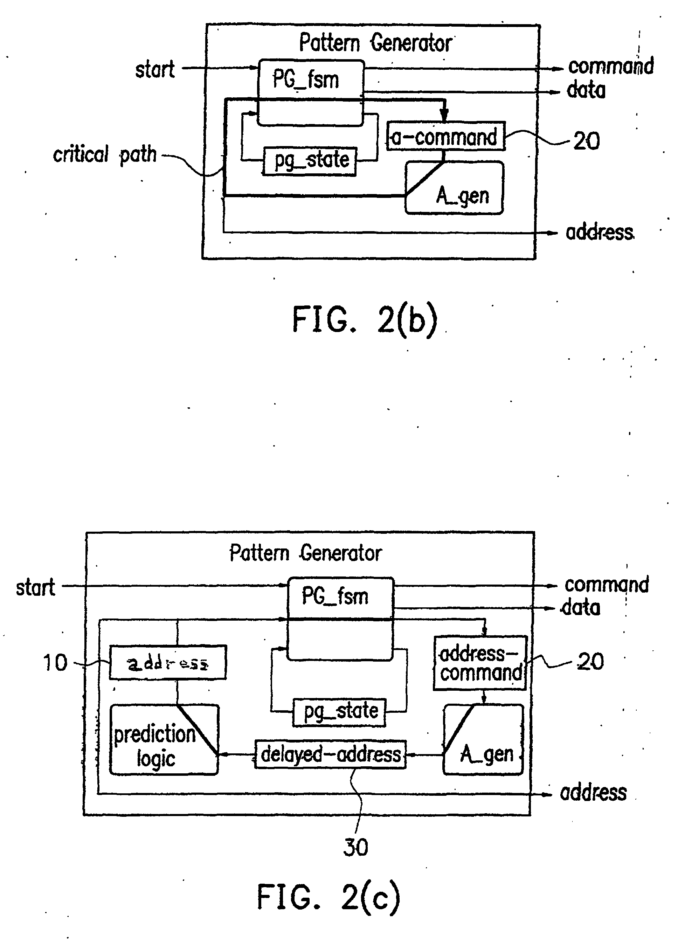

   Figure 2(a) is a naive pattern generator;
   Figure 2(b) is a pattern generator after retiming; and
   Figure 2(c) is a high speed version of pattern generator;

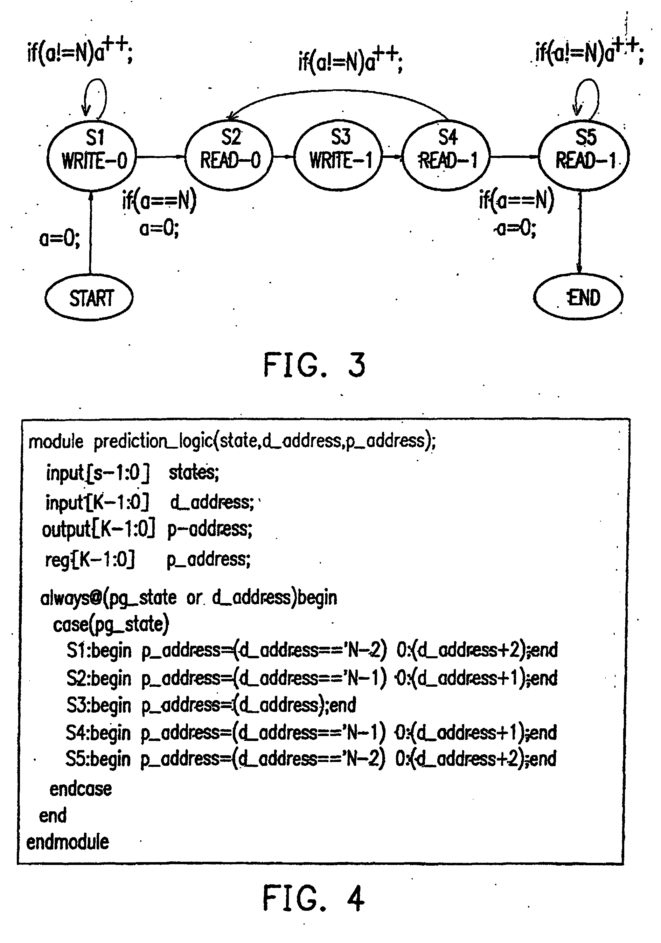

Figure 3 is a state transition graph for March algorithm of a prediction logic; and
Figure 4 shows a register transfer level code for the prediction logic.

### DESCRIPTION OF THE PREFERRED EMBODIMENTS

### The Test Algorithm

While performing a test on a memory device, a test algorithm written as a program in a high-level language is often proposed. Considering a memory device comprising *R* rows and *C* columns is to be tested, four steps are included in a march algorithm. In a first step, '0' is written to every cell. The second step walks through the entire array in a forward manner, that is, from the first cell in the first row to the last cell in the last row. At each cell, a so-called READ(0)-WRITE(1)-READ(1) operation is performed. This READ-WRITE-READ operation is proposed in an attempt to better expose the potential dynamic defects of the memory cells. The third step walks through the entire cell from the last cell to the first cell. At each cell, a READ(1)-WRITE(0)-READ(0) operation is performed. The fourth step of this algorithm checks if the value of every cell is still zero after the first three steps.

An example of this march algorithm programmed in a high-level language is as presented herewith.

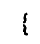

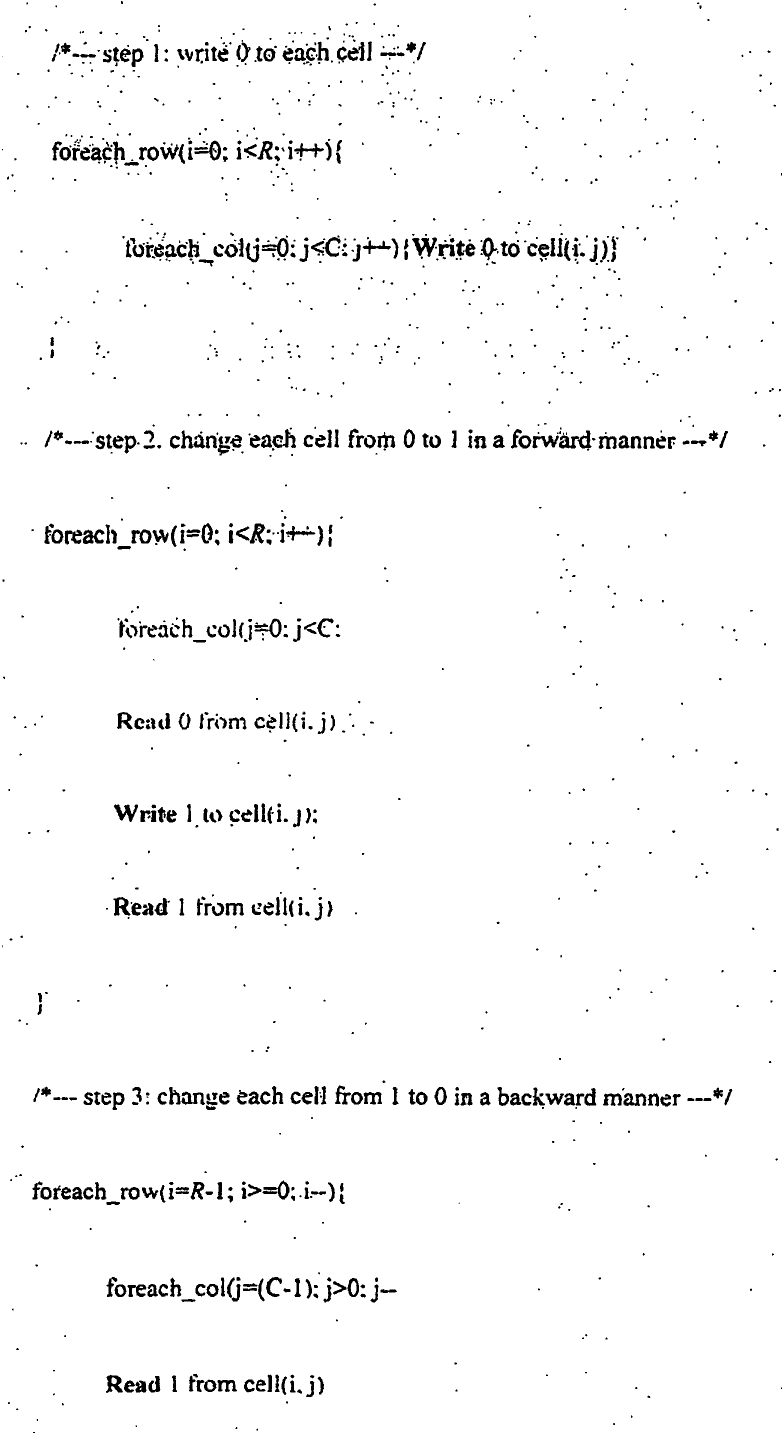

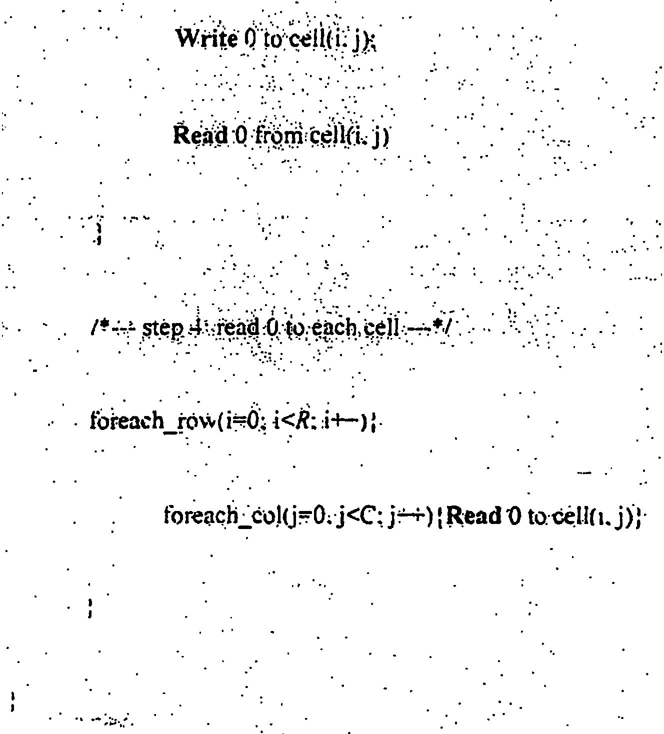

### The Built-In Self-Test Circuit.

A built-in self-test circuit is disclosed in the invention. As shown in Fig. 1, the built-in-self-test circuit comprises a pattern generator, a built-in self-test circuit (BIST) output buffer (BOB), a delay buffer and a comparator.

The pattern generator is a finite state machine which produces a sequence of test patterns. This relates to the above test algorithm. The BOB is a buffer between the BIST circuit and the memory device, for example, an SRAM, to eliminate the potential degradation of the memory device due to the introduction of the BIST circuit. The delay buffer is a first-in-first-out register file between pattern generator and the comparator. It is primarily for computing the expected response of the memory read command. The number of delayed clock cycles depends on the latency of the READ operation of the memory. The comparator is a piece of combinational logic that compares the output responses of the memory with the expected values to determine if the memory is functionally correct, where the expected values are provided by the delay buffer.

Among the four components of the BIST circuit, the pattern generator is the timing critical one that dominates the clock-cycle time. The technique to break a timing critical path is to be described in the following paragraphs.

Fig. 2(a) to Fig. 2(c) shows an evolvement of a pattern generator in a built-in self-test circuit as shown in Fig. 1 according to the invention. Fig. 2(a) shows a structure of a naive pattern generator. As mentioned earlier, the pattern generator is responsible, for generating test patterns each of which comprises portions of data. commands and addresses. The pattern generator can thus be further divided into two modules, that is, a finite state machine denoted as *PG_fsm* and an address generator denoted as *A_gen.* As shown in the figure, the module *PG_fsm* generates the command portion and the data portion of the test patterns, as well as an address command, denoted as *a_command.* The address command *a_command* is used to drive the module *A_gen.* which is responsible for generating the address portion of each test pattern. In this embodiment, nine address commands are used to accommodate various test algorithms. These nine address commands include NO_CHANGE, INIT_ADDRESS, LAST_ADDRESS, NEXT_CELL, PREVIOUS_CELL, Y_NEXT_CELL, Y_PREVIOUS_CELL, CROSS_CELL. and RECALL. According to each address command, the module *A_gen* updates the values of an address register 10 at each clock cycle. In this architecture, it can be seen that the timing critical paths start from the output of the address register 10, pass through the combinational portions of modules *PG_fsm* and *A_gen*, and finally ends at the inputs of the address register 10. In addition, the pattern generator further comprises an original state register for the finite state machine, denoted as *pg_state*.

Retiming transformation is proposed to be an effective means for timing optimization. However, it is not applicable in this design because the critical paths actually form a loop. Fig. 2(b) shows a demonstration of the retiming transformation. The retiming moves the address register 10 backwards across the module *A_gen.* In the retimed version, the timing critical paths are slightly changed, but the clock-cycle time is still dominated by the sum of the propagation delays through the combinational portions of *A_gen* and *PG_fsm*.

The motivation ot the technique of this invention is to break the cyclic paths by inserting registers not only between the modules *PG_fsm* to *A_gen*, but also between the paths from *A_gen* to *PG_fsm*. The idea leads to a new architecture as shown in Fig. 2(c). In addition to the two combination modules *PG_fsm* and *A_gen*, there are four registers and another combinational logic in the new architecture. The four registers comprises the original state register *pg_state*, an original cell address register *address* 10, a register *address-command* 20 representing an address command generated by the *PG_fsm*, and a register *delay-address* 30 representing a cell address delayed by one-clock cycle. It is delayed because of the register added at signal *address command*.

The newly added combinational module, referred to as prediction logic, is the most important part of this technique. Its purpose is to predict an address of a next clock cycle based on the address information of a previous clock cycle. Thus, the timing improved version is indeed equivalent to the original version.

Assume that the cell addresses of the original pattern generator are A1, A2, A3, A4, A5, and A6 for the first six clock cycles. Note that these addresses are not necessarily consecutive. The values of three watch-point signals in the high-speed version, the register *delayed-address* 30, the output of the prediction logic, and the register *address-command* 20 are listed in Table 1.

**Table 1**

| Clock-cycle | | 1 | 2 | 3 | 4 | 5 | 6 |
|---|---|---|---|---|---|---|---|
| Original version | Address | A1 | A2 | A3 | A4 | A5 | A6 |
| High-speed | Delayed-address | - | A1 | A2 | A3 | A4 | A5 |
| | Prediction-address | - | A3 | A4 | A5 | A6 | A7 |
| | Address | - | A2 | A3 | A4 | A5 | A6 |

For example, in the second clock cycle, the current address is A2, while the input of the prediction logic is the delayed one A1. Based on the earlier functional description of the prediction logic, its output should be the address of the next clock cycle, which is A3 The address is delayed by another register before feeding the module *PG_fsm*, therefore, the address input to the *PG_fsm* is still the current address A2, which is the same one in the original version of pattern generator. In this example, the prediction logic needs to predict A3 from A1. This is achievable because the sequence of address change is pre-defined in the underlying test algorithms. The following show the implementation of the prediction logic. The implementation for more complex test algorithms can be derived in a similar way.

### Prediction Logic for March Algorithm

For simplicity without loss of generality, the memory array is assumed one dimensional with N cells. The state transition graph of half March algorithm is shown in Fig. 4, where the variable a labeled on transitions represents the cell address. In addition to the START and END states, there are five states, that is, S1,S2,S3,S4, and S5. Fach state produces a unique test command and data as indicated within each cycle. The register transfer level (RTL) code for the prediction logic is shown in Fig. 4.

Summarizing the above description, the invention provides a built-in self-test circuit for testing a memory device. The most clock-cycle time dominant component is the pattern generator. The pattern generator comprises a finite state machine *PG_fsm*, an address generator *A_gen*, a prediction logic, and three sets of flip-flops. that is, an original cell address register *address*, an address command register *address-command*, and *a delay-address* for cell address delayed by one-clock cycle. In this way, the time critical path is broken into three segments in the *PG_fsm*, the *A_gen*, and the prediction logic. In this way, the clock-cycle times is determined by a longest path among the *PG_fsm*, the *A_gen*, and the prediction logic. Compared to a loop in the naive pattern generator, the clock-cycle time is effectively reduced. Though a latency occurs due to the insertion of the additional registers, signals in these registers are precomputed by one clock-cycle by the prediction logic in advance.

### Synthesis Results

The present invention has been implemented as a register transfer level (RTL) code. It is simulated with the functional model of the memory device under test to establish the confidence of its functional correctness. Synthesis tool, design compile, is used to convert this RTL code into a netlist and perform logic optimization using 0.35µm CMOS technology library. Static timing analysis tool, design time, shows that the clock cycle time is under 2.5ns. The timing-driven feature of a place-and-roat tool. Apollo, is used generate the layout. Post-layout timing check shows no timing violation under above clock cycle time. Based on these results, we thus can conclude the proposed BIST architecture in the invention has great potential to run as fast as 400MHz, which is about 30% speed-up as compared to the naive implementation without the proposed technique.

Other embodiment of the invention will appear to those skilled in the art from consideration of the specification and practice of the invention disclosed herein. It is intended that the specification arid examples to be considered as exemplary only, with a true scope of the invention being indicated by the following claims.

## Claims

1. A built-in self-test circuit for a memory device comprising:
an output buffer, to serve as a buffer between the built-in self-test circuit and the memory device;
a delay huffer, for delaying an expected memory response;
a comparator, to compare an output response of the memory device with the expected memory response provided by the delay buffer, so as to determine whether the memory device functions correctly; and
a pattern generator, comprising:
a finite state machine, to generate a command portion and a data portion of a test pattern;
an address generator, to generate an address portion of the test pattern; said pattern generator **characterized by** further comprising:
a prediction logic, to predict an address of a clock cycle following a previous clock cycle based on an address of the previous clock cycle.

2. The built-in self-test-circuit according to claim 1, wherein the test pattern is generated according to a sequence of memory commands defined by the memory device.

3. The built-in self-test circuit according to claim 1, wherein registers are inserted between the finite state machine, the address generator, and the prediction logic.

4. A pattern generator used in a built-in self-test circuit for testing a memory device, the pattern generator comprising:
a finite state machine to generate an address command, a data portion and a command portion of at least a test pattern;
an address generator, driven by the address command to generate an address portion of the test pattern: and **characterized by** further comprising:
a prediction logic, to predict an address of a clock cycle following a previous clock cycle based on an address of the previous clock cycle.

5. The pattern generator according to claim 4, further comprises:
an address command register (20), inserted between the finite state machine;
a delayed address register (30), inserted between the address generator and the prediction logic; and
an original address register (10), inserted between the prediction logic and the finite state machine.

## Patentansprüche

1. Integrierte Selbsttest-Schaltung für eine Speichereinrichtung, welche aufweist:
einen Ausgangspuffer, der als Puffer zwischen der integrierten Selbsttest-Schaltung und der Speichereinheit dient;
einen Verzögerungspuffer zum Verzögern einer erwarteten Speicherantwort;
einen Komparator, der eine Ausgangsantwort der Speichereinrichtung mit der erwarteten Antwort des Speichers, welche von dem Verzögerungspuffer bereitgestellt wird, vergleicht, um so zu entscheiden, ob die Speichereinheit korrekt funktioniert; und
einen Mustergenerator welcher aufweist:
eine Maschine mit endlich vielen Zuständen, die einen Befehlsteil und einen Datenteil eines Testmusters erzeugt;
einen Adressgenerator, der einen Adressteil des Testmusters erzeugt, wobei der Mustergenerator **dadurch gekennzeichnet ist, dass** er weiterhin aufweist:
eine Voraussagelogik zum Voraussagen einer Adresse eines Taktzyklus, welcher einem vorangegangenen Taktzyklus folgt, basierend auf einer Adresse des vorangegangenen Taktzyklus.

2. Integrierte Selbsttest-Schaltung gemäß Anspruch 1, wobei das Testmuster gemäß einer Sequenz von Speicherbefehlen erzeugt wird, welche mittels der Speichereinheit festgelegt werden.

3. Integrierte Selbsttest-Schaltung gemäß Anspruch 1, wobei Register zwischen die Maschine mit endlich vielen Zuständen, den Adressgenerator und der Voraussagelogik geschaltet sind.

4. Mustergenerator, welcher in einer integrierte Selbsttest-Schaltung zum Testen einer Speichereinrichtung verwendet wird, wobei der Mustergenerator aufweist:
eine Maschine mit endlich vielen Zuständen, um einen Adressbefehl, einen Datenteil und einen Befehlsteil zumindest eines Testmusters zu erzeugen;
einen Adressgenerator, welcher mittels des Adressbefehls angetrieben wird, um einen Adressteil des Testmusters zu erzeugen, und wobei der Mustergenerator **gekennzeichnet** ist, dass er weiterhin aufweist:
eine Voraussagelogik zum Voraussagen einer Adresse eines Taktzyklus, welcher einen vorangegangenen Taktzyklus folgt, basierend auf einer Adresse des vorangegangenen Taktzyklus.

5. Mustergenerator gemäß Anspruch 4, welcher weiterhin aufweist:
ein Adressbefehls-Register (20), welches zwischen die Maschine mit endlich vielen Zuständen geschaltet ist;
ein Verzögerungs-Adressregister (30), welches zwischen den Adressgenerator und der Voraussagelogik geschaltet ist; und
ein Ursprungsadress-Register (10), welches zwischen die Voraussagelogik und die Maschine mit endlich vielen Zuständen geschaltet ist.

## Revendications

1. Un circuit d'auto-test incorporé pour un dispositif de mémoire, comprenant :
un tampon de sortie, pour remplir la fonction d'un tampon entre le circuit d'auto-test incorporé et le dispositif de mémoire;
un tampon de retard pour retarder une réponse de mémoire prévue;
un comparateur pour comparer une réponse de sortie du dispositif de mémoire avec la réponse de mémoire prévue qui est fournie par le tampon de retard, de façon à déterminer si le dispositif de mémoire fonctionne correctement; et
un générateur de configurations, comprenant :
un automate à états finis, pour générer une partie d'ordre et une partie de données d'une configuration de test;
un générateur d'adresse pour générer une partie d'adresse de la configuration de test, ce générateur de configurations étant **caractérisé en ce qu'**il comprend en outre :
une logique de prédiction, pour prédire une adresse d'un cycle d'horloge qui suit un cycle d'horloge précédent, sur la base d'une adresse du cycle d'horloge précédent.

2. Le circuit d'auto-test incorporé selon la revendication 1, dans lequel la configuration de test est générée conformément à une séquence d'ordres de mémoire définie par le dispositif de mémoire.

3. Le circuit d'auto-test incorporé selon la revendication 1, dans lequel des registres sont insérés entre l'automate à états finis, le générateur d'adresse et la logique de prédiction.

4. Un générateur de configurations utilisé dans un circuit d'auto-test incorporé pour tester un dispositif de mémoire, le générateur de configurations comprenant :
un automate à états finis, pour générer un ordre d'adresse, une partie de données et une partie d'ordre d'au moins une configuration de test;
un générateur d'adresse, piloté par l'ordre d'adresse, pour générer une partie d'adresse de la configuration de test; et **caractérisé en ce qu'**il comprend en outre :
une logique de prédiction, pour prédire une adresse d'un cycle d'horloge qui suit un cycle d'horloge précédent, sur la base d'une adresse du cycle d'horloge précédent.

5. La configuration de test selon la revendication 4, comprenant en outre
un registre d'ordre d'adresse (20), inséré entre l'automate à états finis;
un registre d'adresse retardée (30), inséré entre le générateur d'adresse et la logique de prédiction; et
un registre d'adresse d'origine (10), inséré entre la logique de prédiction et l'automate à états finis.
